# EUROPEAN PATENT SPECIFICATION

(11) **EP 2 932 218 B1**
(45) Date of publication and mention of the grant of the patent: **19.09.2018**
(21) Application number: 13798922.4
(22) Date of filing: 28.11.2013
(51) Int. Cl.: G01L 9/00, G01L 9/04, G01L 19/06, G01L 1/22, G01L 9/06, G01L 1/16

(54) **A SENSOR COMPRISING A SUBSTRATE**
SENSOR MIT EINEM SUBSTRAT.
CAPTEUR COMPRENANT UN SUBSTRAT

(30) Priority: 17.12.2012 DK 201200800
(43) Date of publication of application: 21.10.2015
(73) Proprietor: Danfoss A/S, 6430 Nordborg (DK)
(72) Inventor: MATZEN, Steen Moellebjerg, DK-6470 Sydals (DK)
(74) Representative: Keil & Schaafhausen Patent- und Rechtsanwälte PartGmbB
(86) International application number: PCT/DK2013/050400
(87) International publication number: WO 2014/094777

(56) References cited:
- US-A- 4 903 000
- US-A1- 2006 278 012

## Description

### FIELD OF THE INVENTION

The present invention relates to a sensor, such as a pressure sensor, comprising a substrate having measuring electronics including a Wheatstone bridge arranged thereon.

### BACKGROUND OF THE INVENTION

Sensors, such as pressure transmitters, based on piezo resistive MEMS sensor chips are known. For instance, US 6,933,582 discloses a semiconductor sensor including a p-type semiconductor substrate having an n-type semiconductor layer disposed on one surface of the substrate and a p-type diffused resistor disposed in the n-type semiconductor layer. A first electric voltage is applied to the n-type semiconductor layer, a second electric voltage is applied to the substrate, a third electric voltage is applied to the p-type diffused resistor. The first electric voltage is higher than the second and third electric voltages. The sensor ensures stable operation against electric leakage and high noise protection because two depletion layers are formed.

US 5,681,997 discloses a polycrystalline pressure sensor formed by depositing polycrystalline silicon piezo resistors on a polycrystalline sensing diaphragm. The piezo resistors are arranged in a Wheatstone bridge configuration. During operation, an alternating differential signal is applied across the input of the Wheatstone bridge. A measured voltage difference between the output terminals of the Wheatstone bridge is used to detect imbalance in the electrical piezo resistors that corresponds to pressure applied to the sensor.

US2006/0278012 discloses a shield film on top of an oxide film, which covers a substrate comprising a bridge circuit.

### DESCRIPTION OF THE INVENTION

It is an object of embodiments of the invention to provide a sensor which operates in a more reliable manner than prior art sensors.

It is a further object of embodiments of the invention to provide a sensor in which electromagnetic interference (EMI) effects are reduced as compared to prior art sensors. It is an even further object of embodiments of the invention to provide a sensor which has an increased stability, as compared to prior art sensors, at high temperature over time.

According to a first aspect the invention provides a sensor comprising:
- an n-dosed substrate,
- measuring electronics arranged at least partly on the substrate, said measuring electronics comprising a Wheatstone bridge,
- a field shield arranged on the substrate in such a manner that the field shield covers the Wheatstone bridge,
- a power supply arranged to supply electrical voltage to the substrate and the measuring electronics, in such a manner that:
   - a quasi-DC voltage is supplied to the Wheatstone bridge, and
   - a DC voltage is supplied to the substrate, the level of said DC voltage being higher than or equal to the quasi-DC voltage supplied to the Wheatstone bridge.

According to a second aspect the invention provides a sensor comprising:
- a p-dosed substrate,
- measuring electronics arranged at least partly on the substrate, said measuring electronics comprising a Wheatstone bridge,
- a field shield arranged on the substrate in such a manner that the field shield covers the Wheatstone bridge,
- a power supply arranged to supply electrical voltage to the substrate and the measuring electronics, in such a manner that:
   - a quasi-DC voltage is supplied to the Wheatstone bridge, and
   - a DC voltage is supplied to the substrate, the level of said DC voltage being lower than or equal to the quasi-DC voltage supplied to the Wheatstone bridge.

The sensor comprises a substrate. According to the first aspect of the invention, the substrate is an n-dosed substrate, and according to the second aspect of the invention, the substrate is a p-dosed substrate. The substrate may, e.g., be made from a semiconductor material, such as silicon, germanium, gallium arsenide, silicon carbide, etc.

The sensor further comprises measuring electronics arranged at least partly on the substrate. Thus, all of the measuring electronics may be arranged on the substrate. Alternatively, some parts or components of the measuring electronics may be arranged on the substrate, while other parts or components of the measuring electronics may be arranged in other parts of the sensor, and/or arranged outside the sensor and simply connected to the parts or components of the measuring electronics which are arranged on the substrate.

The measuring electronics comprises a Wheatstone bridge. The Wheatstone bridge is preferably arranged on the substrate. The Wheatstone bridge provides the actual measuring performed by the sensor. This will be described in further detail below.

The sensor further comprises a field shield arranged on the substrate in such a manner that the field shield covers the Wheatstone bridge. The field shield thereby provides shielding for the Wheatstone bridge against external electromagnetic fields which could potentially disturb the measurements performed by means of the Wheatstone bridge. The field shield is preferably made from a metal, such as aluminium.

Finally, the sensor comprises a power supply arranged to supply electrical voltage to the substrate and the measuring electronics, in particular to the Wheatstone bridge.

The power supply supplies a quasi-DC voltage to the Wheatstone bridge. In the present context the term 'quasi-DC voltage' should be interpreted to mean a voltage signal which is alternatingly switched between an upper voltage level and a lower voltage level, in such a manner that the upper voltage level is supplied to one node of the Wheatstone bridge when the lower voltage level is supplied to another node of the Wheatstone bridge, and vice versa. At specified time intervals, the voltage levels are reversed, so that the voltage level supplied to one node is switched from the upper level to the lower level, while the voltage level supplied to the another node is switched from the lower level to the upper level, etc.

Furthermore, the power supply supplies a DC voltage to the substrate. In the case that the sensor is a sensor according to the first aspect of the invention, i.e. in the case that the substrate is an n-dosed substrate, the level of the DC voltage supplied to the substrate is higher than or equal to the quasi-DC voltage supplied to the Wheatstone bridge. Similarly, in the case that the sensor is a sensor according to the second aspect of the invention, i.e. in the case that the substrate is a p-dosed substrate, the level of the DC voltage supplied to the substrate is lower than or equal to the quasi-DC voltage supplied to the Wheatstone bridge. Thereby it is ensured that a voltage difference between the voltage supplied to the substrate and to the Wheatstone bridge is present, at least for a part of the period defined by the quasi- DC voltage. This has the consequence that the electron leakage, as well as electrical capacitance between the four nodes of the Wheatstone bridge and a casing or chassis of the sensor is reduced, as compared to a situation where the voltage supplied to the Wheatstone bridge is equal to the voltage supplied to the substrate at any time. The thickness of the depletion layer increases with voltage, thus minimizing the capacitance. Minimizing the capacitive coupling between the sensing element and the outer casing or chassis of the sensor will minimize the electromagnetic interference (EMI) effects of the sensor, thereby improving EMC common mode performance. Furthermore, the sensor operates in a very reliable manner. This is because the temperature stability of the sensor is improved by minimising diffusion caused by DC voltage of free ions, thus minimising changes in piezo resistive properties.

The power supply may further be arranged to supply a voltage to the field shield. In the case that the sensor is a sensor according to the first aspect of the invention, i.e. in the case that the substrate is an n-dosed substrate, the level of the voltage supplied to the field shield is higher than or equal to the quasi-DC voltage supplied to the Wheatstone bridge. Similarly, in the case that the sensor is a sensor according to the second aspect of the invention, i.e. in the case that the substrate is a p-dosed substrate, the level of the voltage supplied to the field shield is lower than or equal to the quasi-DC voltage supplied to the Wheatstone bridge. Thus, according to this embodiment, a voltage difference exists between the voltage supplied to the field shield, and either the voltage supplied to the Wheatstone bridge or the voltage supplied to the substrate. Thereby the sensor is efficiently shielded against external electrical fields, and the sensor operates in a very reliable manner.

The level of the DC voltage supplied to the substrate may be equal to the level of the voltage supplied to the field shield. This may, e.g., be obtained by providing a direct electrical connection between the field shield and the substrate. According to this embodiment, the voltage supplied to the field shield is a DC voltage.

As an alternative, the voltage supplied to the field shield may follow the 'quasi-DC voltage supplied to the Wheatstone bridge. This may, e.g., be obtained by providing a direct electrical connection between the field shield and the Wheatstone bridge. According to this embodiment, the voltage supplied to the field shield is a quasi-DC voltage.

The difference between the DC voltage level supplied to the substrate and the quasi-DC voltage supplied to the Wheatstone bridge may be at least 0.5 V, such as at least 1.0 V, such as at least 3.0 V, such as at least 5.0 V, such as at least 7.0 V, such as at least 10.0 V. This is an advantage, because a large difference between the voltage levels minimises the capacitance between the four nodes of the Wheatstone bridge and a casing or chassis of the sensor. However, electron leakage and diffusion, which would be a problem at large voltage differences in the case that a DC voltage was supplied to the Wheatstone bridge as well as to the substrate, is minimised due to the quasi-DC voltage supplied to the Wheatstone bridge. The measuring electronics may further comprise one or more resistors, each resistor being electrically connected between the power supply and an excitation node of the Wheatstone bridge. The voltage drop provided by the resistors, bias the diodes of the Wheatstone bridge in the reverse direction. In the case that the sensor is a sensor according to the first aspect of the invention, i.e. in the case that the substrate is an n-dosed substrate, this reduces the voltage level supplied by the power supply, and the 'quasi-DC voltage level supplied to the Wheatstone bridge is thereby reduced as compared to the original DC voltage level provided by the power supply, and which is also supplied to the substrate. Similarly, in the case that the sensor is a sensor according to the second aspect of the invention, i.e. in the case that the substrate is a p-dosed substrate, this increases the voltage level supplied by the power supply, and the quasi-DC voltage level supplied to the Wheatstone bridge is thereby increased as compared to the original DC voltage level provided by the power supply, and which is also supplied to the substrate. Thus, according to this embodiment, a difference in voltage level between the substrate and the Wheatstone bridge is present throughout the period defined by the 'quasi-DC voltage supplied to the Wheatstone bridge.

In the case that the sensor is a sensor according to the first aspect of the invention, i.e. in the case that the substrate is an n-dosed substrate, the Wheatstone bridge may be formed by p-dosed resistors implemented in the substrate. Similarly, in the case that the sensor is a sensor according to the second aspect of the invention, i.e. in the case that the substrate is a p-dosed substrate, the Wheatstone bridge may be formed by n-dosed resistors implemented in the substrate. According to this embodiment, the Wheatstone bridge is formed directly into the substrate.

The sensor may be a piezo-resistive MEMS sensor chip.

The measuring electronics may further comprise a switching arrangement, said switching arrangement being arranged to generate a quasi-DC voltage signal and to supply the generated quasi-DC voltage signal to the Wheatstone bridge. According to this embodiment, the power supply is a DC power supply, and the switching arrangement ensures that the voltage supplied to the Wheatstone bridge is a quasi-DC voltage.

The sensor may be a pressure sensor. As an alternative, the sensor may be a temperature sensor, a strain gauge, a stress gauge, or any other suitable kind of sensor.

### BRIEF DESCRIPTION OF THE DRAWINGS

The invention will now be described in further detail with reference to the accompanying drawings in which
Fig. 1 is a diagrammatic view of a sensor according to a first embodiment of the invention,
Fig. 2 is a diagrammatic view of a sensor according to a second embodiment of the invention,
Fig. 3 illustrates voltages supplied to the sensor of Fig. 1, and
Fig. 4 is a cross sectional view of a sensor according to an embodiment of the invention.

### DETAILED DESCRIPTION OF THE DRAWINGS

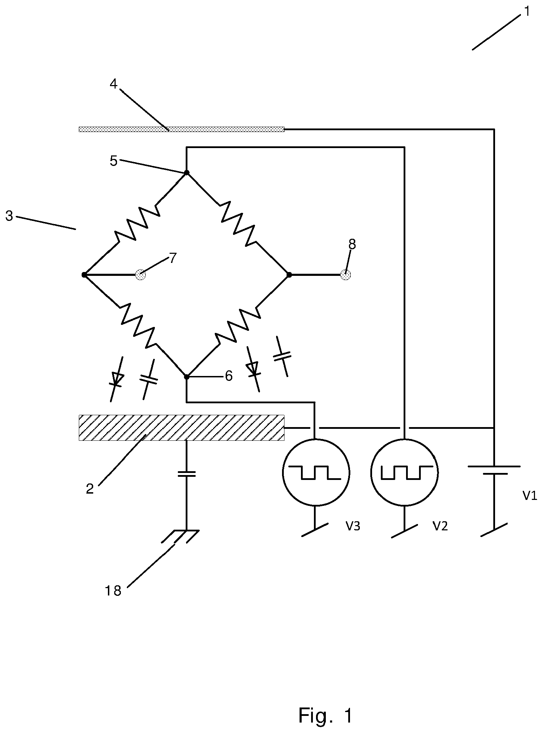

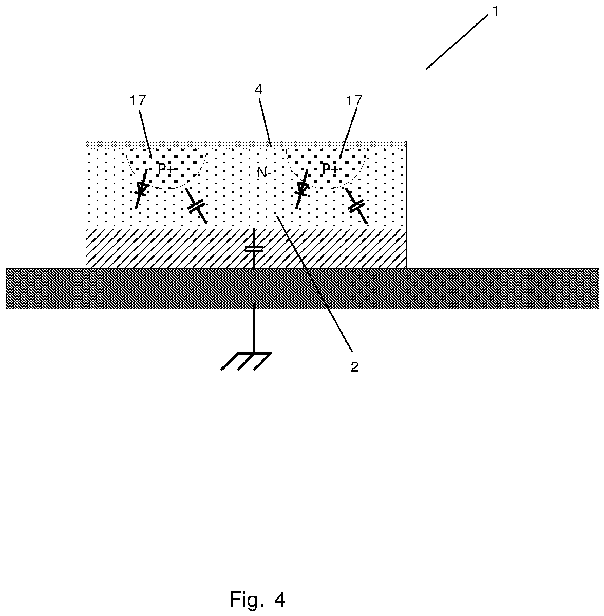

Fig. 1 is a diagrammatic view of a sensor 1 according to a first embodiment of the invention. The sensor 1 comprises an n-dosed substrate 2. It should be noted that, even though the substrate 2 illustrated in Fig. 1 is an n-dosed substrate, it is within the scope of the present invention that the substrate 2 could be a p-dosed substrate. In this case the anode cathode of the illustrated diodes should be reversed. A Wheatstone bridge 3 is arranged on the substrate 2, e.g. formed directly in the substrate 2 in a manner which will be described below with reference to Fig. 4.

A field shield 4 is arranged on the substrate 2 in such a manner that it covers the Wheatstone bridge 3. Thereby the field shield 4 shields the Wheatstone bridge 3 against external electrical fields.

A power supply is arranged to supply a first voltage level, V₁, in the form of a DC voltage to the substrate 2 and to the field shield 4. Furthermore, the power supply supplies a second voltage level, V₂, in the form of a first quasi-DC voltage to a first node 5 of the Wheatstone bridge 3, and a third voltage level, V₃, in the form of a second 'quasi-DC voltage to a second node 6 of the Wheatstone bridge 3. Accordingly, the voltages, V₂ and V₃, both alternate between an upper level and a lower level in such a manner that the voltage is initially maintained substantially constant at the upper level, then switched abruptly to the lower level and maintained substantially constant at the lower level before being switched abruptly back to the upper level, etc. Thus, each of the quasi-DC voltages, V₂ and V₃, defines a period, e.g. being the time elapsing from the voltage is switched to the upper level until the voltage is once again switched to the upper level. Furthermore, when the upper voltage level is supplied to the first node 5, the lower voltage level is supplied to the second node 6, and vice versa.

It is an advantage that quasi-DC voltages, V₂ and V₃, are supplied to the nodes 5, 6 of the Wheatstone bridge 3, because this minimizes the diffusion of ions, which could pollute the resistors of the Wheatstone bridge 3. Thereby the performance of the sensor 1 can be improved.

In the case that the substrate 2 is an n-dosed substrate, the quasi-DC voltages, V₂ and V₃, are selected in such a manner that, at any time during a period of the quasi-DC voltages, the DC voltage, V₁, is higher than or equal to the quasi-DC voltages, V₂ and V₃. Thus, the quasi-DC voltages, V₂ and V₃, may be equal to the DC voltage, V₁, during the part of the period where the quasi-DC voltages are at the upper voltage level. However, for the remaining part of the period, i.e. when the quasi-DC voltages are at the lower voltage level, the DC voltage, V₁, which is supplied to the substrate 2 and to the field shield 4, will be higher than the quasi-DC voltages, V₂ and V₃. The DC voltage, V₁, may even be higher than the quasi-DC voltages, V₂ and V₃, during the entire period of the 'quasi-DC voltages.

Similarly, in the case that the substrate 2 is a p-dosed substrate, the quasi-DC voltages, V₂ and V₃, are selected in such a manner that, at any time during a period of the quasi-DC voltages, the DC voltage, V₁, is lower than or equal to the quasi-DC voltages, V₂ and V₃. Thus, similarly to what is described above, the DC voltage, V₁, is lower than the quasi-DC voltages, V₂ and V₃, for at least a part of the period defined by the quasi-DC voltages.

Accordingly, regardless of whether the substrate 2 is an n-dosed substrate or a p-dosed substrate, a voltage difference exists between the voltage level supplied to the substrate 2 and the field shield 4, on the one hand, and the first 5 and second 6 nodes of the Wheatstone bridge 3, on the other hand, at least for a part of the period defined by the quasi-DC voltages. This ensures that the capacitance between the four nodes of the Wheatstone bridge 3 and a casing or chassis 18 of the sensor 1 is minimised, and thereby that the electromagnetic interference effects are reduced.

The sensor 1 of Fig. 1 may be operated in the following manner. Measuring electronics are connected to nodes 7 and 8 of the Wheatstone bridge 3. Voltages are supplied to the substrate 2, the field shield 4 and the first 5 and second 6 nodes of the Wheatstone bridge 3 as described above. Changes in a quantity to be measured, such as pressure, strain, stress, temperature, etc., cause the resistances of the resistors of the Wheatstone bridge 3 to change. This will, in turn, cause the voltage difference between nodes 7 and 8 to change. This change in voltage difference is detected by the measuring electronics, and is used for deriving the changes in the quantity being measured. With an appropriate calibration of the sensor 1, an absolute value of the quantity being measured can be derived.

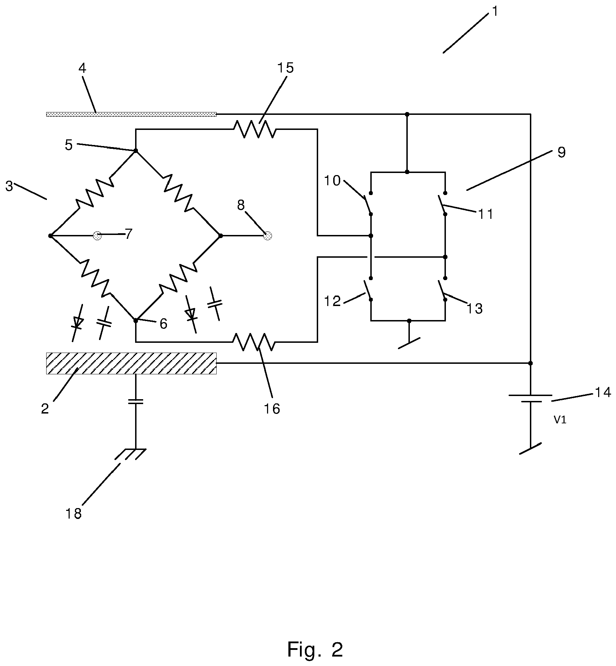

Fig. 2 is a diagrammatic view of a sensor 1 according to a second embodiment of the invention. The sensor 1 of Fig. 2 is very similar to the sensor 1 of Fig. 1, and it will therefore not be described in detail here.

The sensor 1 of Fig. 2 comprises a switching arrangement 9 comprising four switches 10, 11, 12, 13 which can be alternatingly opened and closed. In Fig. 2 all four switches 10, 11, 12, 13 are shown in the open position. The switching arrangement 9 is electrically connected between a DC power supply 14 and the Wheatstone bridge 3. The DC power supply 14 is also electrically connected to the substrate 2 and the field shield 4 in such a manner that the DC voltage level supplied by the power supply 14 is the DC voltage level which is supplied to the substrate 2 and the field shield 4.

When switch 10 and switch 13 are closed, and switch 11 and switch 12 are open, an upper voltage level is supplied to the first node 5 of the Wheatstone bridge 3, and a lower voltage level is supplied to the second node 6 of the Wheatstone bridge 3. Similarly, when switch 10 and switch 13 are open, and switch 11 and switch 12 are closed, a lower voltage level is supplied to the first node 5 of the Wheatstone bridge 3, and an upper voltage level is supplied to the second node 6 of the Wheatstone bridge 3. Thus, by switching the switches 10, 11, 12, 13 of the switching arrangement 9 in an appropriate manner, the quasi-DC voltages illustrated in Fig. 1 can be supplied to the Wheatstone bridge 3.

A first biasing resistor 15 is arranged between the switching arrangement 9 and the first node 5 of the Wheatstone bridge 3, and a second biasing resistor 16 is arranged between the switching arrangement 9 and the second node 6 of the Wheatstone bridge 3. The biasing resistors 15, 16 lower the voltage level supplied by the DC power supply 14. Thereby, even the upper voltage level of the quasi-DC voltages supplied to the first 5 and second 6 nodes of the Wheatstone bridge 3, is lower than the DC voltage level supplied to the substrate 2 and the field shield 4.

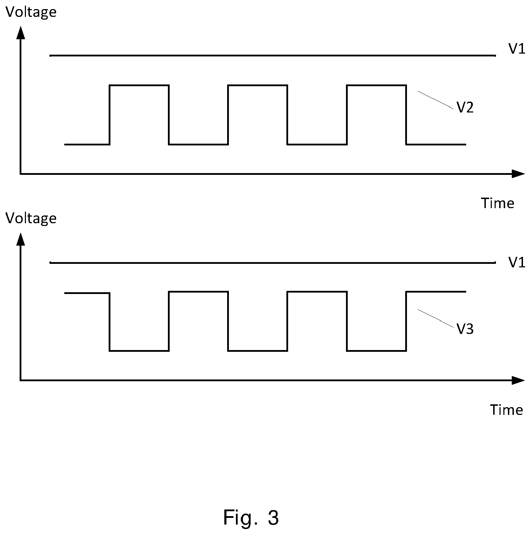

Fig. 3 illustrates the voltage levels, V₁, V₂ and V₃, supplied to the substrate 2, the field shield 4 and the Wheatstone bridge 3 of the sensor 1 of Fig. 1, as a function of time. Fig. 3 illustrates the situation where the substrate 2 is an n-dosed substrate.

It is clear from Fig. 3 that the DC voltage, V₁, supplied to the substrate 2 and to the field shield 4, is higher than the quasi-DC voltages, V₂ and V₃, supplied to the first 5 and second 6 nodes, respectively, of the Wheatstone bridge 3, at all times. It can also be seen that when the quasi-DC voltage, V₂, supplied to the first node 5 of the Wheatstone bridge 3 is at the upper level, the 'quasi-DC voltage, V₃, supplied to the second node 6 of the Wheatstone bridge 3 is at the lower level, and vice versa.

Fig. 4 is a cross sectional view of a sensor 1 according to an embodiment of the invention. The sensor 1 comprises an n-dosed substrate 2, into which resistors 17 of a p-dosed material are formed. The resistors 17 form a Wheatstone bridge, and the sensor 1 may therefore, e.g., be of the kind shown in Fig. 1 or of the kind shown in Fig. 2.

A field shield 4 is arranged on the substrate 2 in such a manner that it covers the resistors 17.

Voltages can be supplied to the substrate 2, the field shield 4 and the resistors 17 in the manner described above.

## Claims

1. A sensor (1) comprising:
- an n-dosed substrate (2),
- measuring electronics arranged at least partly on the substrate (2), said measuring electronics comprising a Wheatstone bridge (3), **characterised by**
- a field shield (4) arranged on the substrate (2) in such a manner that the field shield (4) covers the Wheatstone bridge (3),
- a power supply arranged to supply electrical voltage to the substrate (2) and the measuring electronics, in such a manner that:
- a quasi-DC voltage is supplied to the Wheatstone bridge (3), and
- a DC voltage is supplied to the substrate (2), the level of said DC voltage being higher than or equal to the quasi-DC voltage supplied to the Wheatstone bridge (3).

2. A sensor (1) according to claim 1, wherein the power supply is further arranged to supply electrical voltage to the field shield (4) in such a manner that the level of the voltage supplied to the field shield is higher than or equal to the quasi-DC voltage supplied to the Wheatstone bridge (3).

3. A sensor (1) according to claim 2, wherein the level of the DC voltage supplied to the substrate (2) is equal to the level of the voltage supplied to the field shield (4).

4. A sensor (1) according to claim 2, wherein the voltage supplied to the field shield (4) follows the 'quasi-DC voltage supplied to the Wheatstone bridge (3).

5. A sensor (1) according to any of the preceding claims, wherein the difference between the DC voltage level supplied to the substrate (2) and the 'quasi-DC voltage supplied to the Wheatstone bridge (3) is at least 0.5 V.

6. A sensor according to any of the preceding claims, wherein the measuring electronics further comprises one or more resistors (15, 16), each resistor (15, 16) being electrically connected between the power supply and an excitation node (5, 6) of the Wheatstone bridge (3).

7. A sensor (1) according to any of the preceding claims, wherein the Wheatstone bridge (3) is formed by p-dosed resistors (17) implemented in the substrate (2).

8. A sensor (1) according to any of the preceding claims, wherein the sensor (1) is a piezo-resistive MEMS sensor chip.

9. A sensor (1) according to any of the preceding claims, wherein the measuring electronics further comprises a switching arrangement (9), said switching arrangement (9) being arranged to generate a quasi-DC voltage signal and to supply the generated quasi-DC voltage signal to the Wheatstone bridge (3).

10. A sensor (1) according to any of the preceding claims, wherein the sensor (1) is a pressure sensor.

11. A sensor (1) comprising:
- a p-dosed substrate (2),
- measuring electronics arranged at least partly on the substrate (2), said measuring electronics comprising a Wheatstone bridge (3), **characterised by**
- a field shield (4) arranged on the substrate (2) in such a manner that the field shield covers the Wheatstone bridge (3),
- a power supply arranged to supply electrical voltage to the substrate (2) and the measuring electronics, in such a manner that:
- a quasi-DC voltage is supplied to the Wheatstone bridge (3), and
- a DC voltage is supplied to the substrate (2), the level of said DC voltage being lower than or equal to the quasi-DC voltage supplied to the Wheatstone bridge (3).

12. A sensor (1) according to claim 11, wherein the power supply is further arranged to supply electrical voltage to the field shield (4) in such a manner that the level of the voltage supplied to the field shield is lower than or equal to the quasi-DC voltage supplied to the Wheatstone bridge (3).

13. A sensor (1) according to claim 11 or 12, wherein the Wheatstone bridge (3) is formed by n-dosed resistors (17) implemented in the substrate (2).

14. A sensor (1) according to any of claims 11-13, wherein the sensor (1) is a pressure sensor.

## Patentansprüche

1. Sensor (1), umfassend:
- ein n-dotiertes Substrat (2),
- Messelektronik, die zumindest teilweise auf dem Substrat (2) angeordnet ist, wobei die Messelektronik eine Wheatstone-Brücke (3) umfasst,
**gekennzeichnet durch**
- eine Feldabschirmung (4), die derart auf dem Substrat (2) angeordnet ist, dass die Feldabschirmung (4) die Wheatstone-Brücke (3) abdeckt,
- eine Stromversorgung, die so angeordnet ist, dass sie dem Substrat (2) und der Messelektronik eine elektrische Spannung zuführt, und zwar derart, dass:
- der Wheatstone-Brücke (3) eine Quasi-Gleichspannung zugeführt wird, und
- dem Substrat (2) eine Gleichspannung zugeführt wird, wobei der Pegel der Gleichspannung größer oder gleich der an die Wheatstone-Brücke (3) gelieferten Quasi-Gleichspannung ist.

2. Sensor (1) nach Anspruch 1, wobei die Stromversorgung ferner so angeordnet ist, dass sie der Feldabschirmung (4) eine elektrische Spannung zuführt, so dass der Pegel der der Feldabschirmung zugeführten Spannung größer oder gleich der der Wheatstone-Brücke (3) zugeführten Quasi-Gleichspannung ist.

3. Sensor (1) nach Anspruch 2, wobei der Pegel der dem Substrat (2) zugeführten Gleichspannung gleich dem Pegel der der Feldabschirmung (4) zugeführten Spannung ist.

4. Sensor (1) nach Anspruch 2, wobei die der Feldabschirmung (4) zugeführte Spannung der der Wheatstone-Brücke (3) zugeführten Quasi-Gleichspannung folgt.

5. Sensor (1) nach einem der vorstehenden Ansprüche, wobei die Differenz zwischen dem dem Substrat (2) zugeführten Gleichspannungspegel und der der Wheatstone-Brücke (3) zugeführten Quasi-Gleichspannung mindestens 0,5 V beträgt.

6. Sensor nach einem der vorstehenden Ansprüche, wobei die Messelektronik ferner einen oder mehrere Widerstände (15, 16) umfasst, wobei jeder Widerstand (15, 16) zwischen der Stromversorgung und einem Erregerknoten (5, 6) der Wheatstone-Brücke (3) elektrisch verbunden ist.

7. Sensor (1) nach einem der vorstehenden Ansprüche, wobei die Wheatstone-Brücke (3) durch p-dotierte Widerstände (17) gebildet wird, die in dem Substrat (2) implementiert sind.

8. Sensor (1) nach einem der vorstehenden Ansprüche, wobei der Sensor (1) ein piezoresistiver MEMS-Sensorchip ist.

9. Sensor (1) nach einem der vorstehenden Ansprüche, wobei die Messelektronik ferner eine Schaltanordnung (9) umfasst, wobei die Schaltanordnung (9) so angeordnet ist, dass sie ein Quasi- Gleichspannungssignal erzeugt und das erzeugte Quasi- Gleichspannungssignal der Wheatstone Brücke (3) zuführt.

10. Sensor (1) nach einem der vorstehenden Ansprüche, wobei der Sensor (1) ein Drucksensor ist.

11. Sensor (1), umfassend:
- ein p-dotiertes Substrat (2),
- Messelektronik, die zumindest teilweise auf dem Substrat (2) angeordnet ist, wobei die Messelektronik eine Wheatstone-Brücke (3) umfasst,
**gekennzeichnet durch**
- eine Feldabschirmung (4), die derart auf dem Substrat (2) angeordnet ist, dass die Feldabschirmung die Wheatstone-Brücke (3) abdeckt,
- eine Stromversorgung, die so angeordnet ist, dass sie dem Substrat (2) und der Messelektronik eine elektrische Spannung zuführt, und zwar derart, dass:
- der Wheatstone-Brücke (3) eine Quasi-Gleichspannung zugeführt wird, und
- dem Substrat (2) eine Gleichspannung zugeführt wird, wobei der Pegel der Gleichspannung kleiner oder gleich der an die Wheatstone-Brücke (3) gelieferten Quasi-Gleichspannung ist.

12. Sensor (1) nach Anspruch 11, wobei die Stromversorgung ferner so angeordnet ist, dass sie der Feldabschirmung (4) eine elektrische Spannung zuführt, so dass der Pegel der der Feldabschirmung zugeführten Spannung kleiner oder gleich der der Wheatstone-Brücke (3) zugeführten Quasi-Gleichspannung ist.

13. Sensor (1) nach einem der Ansprüche 11 oder 12, wobei die Wheatstone-Brücke (3) durch n-dotierte Widerstände (17) gebildet wird, die in dem Substrat (2) implementiert sind.

14. Sensor (1) nach einem der Ansprüche 11-13, wobei der Sensor (1) ein Drucksensor ist.

## Revendications

1. Capteur (1) comprenant :
un substrat dopé n (2),
une électronique de mesure agencée au moins en partie sur le substrat (2), ladite électronique de mesure comprenant un pont de Wheatstone (3),
**caractérisé par**
un blindage de champ (4) agencé sur le substrat (2) d'une telle manière que le blindage de champ (4) recouvre le pont de Wheatstone (3),
une alimentation électrique agencée pour fournir une tension électrique au substrat (2) et à l'électronique de mesure, d'une telle manière que :
une tension quasi-CC est fournie au pont de Wheatstone (3), et
une tension CC est fournie au substrat (2), le niveau de ladite tension CC étant supérieur ou égal à la tension quasi-CC fournie au pont de Wheatstone (3).

2. Capteur (1) selon la revendication 1, l'alimentation électrique étant en outre agencée pour fournir une tension électrique au blindage de champ (4) d'une telle sorte que le niveau de la tension fournie au blindage de champ est supérieur ou égal à la tension quasi-CC fournie au pont de Wheatstone (3).

3. Capteur (1) selon la revendication 2, le niveau de la tension CC fournie au substrat (2) étant égal au niveau de la tension fournie au blindage de champ (4).

4. Capteur (1) selon la revendication 2, la tension fournie au blindage de champ (4) suivant la tension quasi-CC fournie au pont de Wheatstone (3).

5. Capteur (1) selon l'une quelconque des revendications précédentes, la différence entre le niveau de tension CC fournie au substrat (2) et la tension quasi-CC fournie au pont de Wheatstone (3) étant d'au moins 0,5 V.

6. Capteur selon l'une quelconque des revendications précédentes, l'électronique de mesure comprenant en outre une ou plusieurs résistances (15, 16), chaque résistance (15, 16) étant connectée électriquement entre l'alimentation électrique et un noeud d'excitation (5, 6) du pont de Wheatstone (3).

7. Capteur (1) selon l'une quelconque des revendications précédentes, le pont de Wheatstone (3) étant formé par des résistances (17) dopées p mises en oeuvre dans le substrat (2).

8. Capteur (1) selon l'une quelconque des revendications précédentes, le capteur (1) étant une puce de capteur MEMS piézorésistive.

9. Capteur (1) selon l'une quelconque des revendications précédentes, l'électronique de mesure comprenant en outre un agencement de commutation (9), ledit agencement de commutation (9) étant agencé pour générer un signal de tension quasi-CC et pour fournir le signal de tension quasi-CC généré au pont de Wheatstone (3).

10. Capteur (1) selon l'une quelconque des revendications précédentes, le capteur (1) étant un capteur de pression.

11. Capteur (1) comprenant :
un substrat dopé p (2),
une électronique de mesure agencée au moins en partie sur le substrat (2), ladite électronique de mesure comprenant un pont de Wheatstone (3),
**caractérisé par**
un blindage de champ (4) agencé sur le substrat (2) d'une telle manière que le blindage de champ recouvre le pont de Wheatstone (3),
une alimentation électrique agencée pour fournir une tension électrique au substrat (2) et à l'électronique de mesure, d'une telle manière que :
une tension quasi-CC est fournie au pont de Wheatstone (3), et
une tension CC est fournie au substrat (2), le niveau de ladite tension CC étant inférieur ou égal à la tension quasi-CC fournie au pont de Wheatstone (3).

12. Capteur (1) selon la revendication 11, l'alimentation électrique étant en outre agencée pour fournir une tension électrique au blindage de champ (4) d'une telle sorte que le niveau de la tension fournie au blindage de champ est inférieur ou égal à la tension quasi-CC fournie au pont de Wheatstone (3).

13. Capteur (1) selon la revendication 11 ou 12, le pont de Wheatstone (3) étant formé par des résistances dopées n (17) mises en oeuvre dans le substrat (2).

14. Capteur (1) selon l'une quelconque des revendications 11 à 13, le capteur (1) étant un capteur de pression.
